**Europäisches Patentamt**

**European Patent Office**

**Office européen des brevets**

(11) Numéro de publication: **0 311 504 B1**

## FASCICULE DE BREVET EUROPEEN

(45) Date de publication de fascicule du brevet: **08.12.93** (51) Int. Cl.5: **H03J 7/32**

(21) Numéro de dépôt: **88402503.2**

(22) Date de dépôt: **04.10.88**

(54) **Procédé et dispositif pour la détection automatique d'émissions radioélectriques de signaux.**

(30) Priorité: **09.10.87 FR 8713965**

(43) Date de publication de la demande:
**12.04.89 Bulletin 89/15**

(45) Mention de la délivrance du brevet:
**08.12.93 Bulletin 93/49**

(84) Etats contractants désignés:
**DE GB IT**

(56) Documents cités:
**EP-A- 0 077 248**
**DE-A- 2 812 954**

(73) Titulaire: **THOMSON-CSF**
**51, Esplanade du Général de Gaulle**
**F-92800 Puteaux(FR)**

(72) Inventeur: **Bensadou, Jean-Claude**
**THOMSON-CSF**
**SCPI**
**19, avenue de Messine**
**F-75008 Paris(FR)**

(74) Mandataire: **Lincot, Georges et al**
**THOMSON-CSF,**
**SCPI,**
**B.P. 329,**
**50, rue Jean-Pierre Timbaud**
**F-92402 Courbevoie Cédex (FR)**

## Description

La présente invention concerne un procédé et un dispositif pour la détection automatique d'émissions radioélectriques de signaux.

Elle s'applique notamment à la réalisation de récepteurs de radiosurveillance.

Dans ces récepteurs il est nécessaire, pour avoir une bonne sensibilité de détection, de disposer d'un seuil de détection le plus faible possible pour détecter des signaux d'énergie très faible. Cependant plus le seuil de détection est faible plus il y a de risque d'autoriser la détection sur des composantes de bruit, entraînant ainsi un grand nombre de fausses alarmes. Pour pallier cet inconvénient le seuil de détection est généralement calculé en fonction de la valeur actuelle du bruit qui est présent à l'entrée du récepteur et un seuil de détection optimal est calculé par une estimation en temps réel de la valeur moyenne de la puissance du bruit atmosphérique, ce dernier dépendant chaque fois de paramètres physiques inhérents au lieu, à la saison, et à l'heure des observations. Enfin, lorsque la valeur moyenne de la puissance du bruit atmosphérique est déterminée, l'exploitant du récepteur règle le seuil de détection à une valeur qui est au-dessus d'un nombre déterminé de décibels, de la valeur moyenne de la puissance du bruit atmosphérique. Ce seuil est généralement choisi en fonction du taux de fausses alarmes tolérable par l'opérateur.

Dans les récepteurs de radiosurveillance connus cette méthode qui requiert l'intervention manuelle d'un opérateur prend du temps et est généralement incompatible avec les exigences de détection rapide demandées des récepteurs de radiosurveillance.

Le but de l'invention est de pallier les inconvénients précités.

Un dispositif de détection automatique d'émissions radioélectriques est cependant décrit dans la demande de brevet EP 0077248, mais celui-ci présente l'inconvénient d'être onéreux à mettre en oeuvre car il nécessite plusieurs chaînes de réception.

A cet effet, l'invention a pour objet le procédé suivant la revendication 1, qui est un procédé de détection automatique par un récepteur, d'émissions radioélectriques de signaux, du type dans lequel le seuil de détection est fixé en fonction d'une estimation en temps réel de la valeur moyenne de la puissance de bruit atmosphérique caractérisé en ce qu'il consiste pour estimer la valeur du bruit, à prélever des échantillons de bruit et/ou de signal utile reçus à l'entrée du récepteur, à discriminer les échantillons de bruit des échantillons de signal utile, et à calculer une valeur moyenne des échantillons de bruit sur un nombre déterminé N d'échantillons, le seuil de détection étant déterminé par la probabilité pour que l'amplitude instantanée du bruit présent à tout instant à l'entrée du récepteur ne dépasse pas d'un nombre déterminé de décibels le seuil de détection.

L'invention a également pour objet un dispositif selon la revendication 2 pour la mise en oeuvre du procédé précité.

Elle a pour principal avantage de permettre un calcul automatique de l'estimée de la valeur moyenne du bruit et de permettre en fonction d'un taux de fausse alarme déterminé de discriminer très rapidement la composante utile du signal des composantes de bruit atmosphérique appliquées à l'entrée des récepteurs de radiosurveillance.

D'autres caractéristiques et avantages de l'invention apparaîtront ci-après à l'aide de la description qui va suivre faite en regard des dessins annexés qui représentent :

- la figure 1 un exemple de réalisation d'un dispositif pour la mise en oeuvre du procédé selon l'invention.
- la figure 2 un organigramme illustrant la mise en oeuvre de calcul de l'estimation de bruit selon l'invention.
- la figure 3 un graphe représentatif de la loi de probabilité pour que, en valeur crête, les points de bruit soient supérieurs de K fois la valeur moyenne $E_{eff}$ du bruit pour permettre de déterminer un seuil de décision à partir d'un taux de fausses alarmes déterminé.

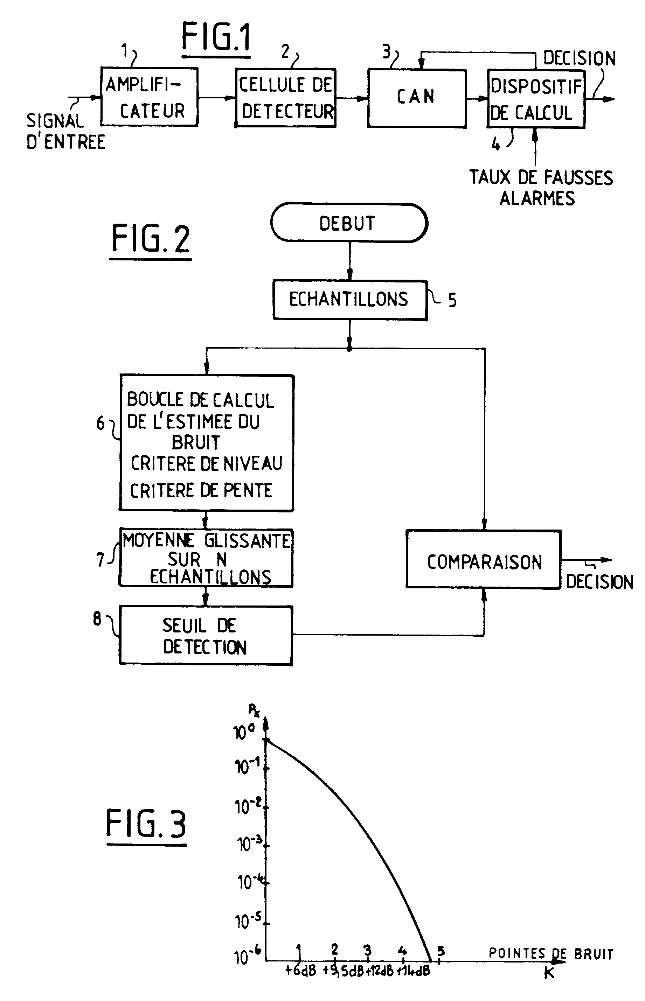

Le dispositif pour la mise en oeuvre du procédé selon l'invention qui est représenté à la figure 1 comprend un amplificateur logarithmique 1, une cellule de détection 2, un convertisseur analogique-numérique 3 et un dispositif de calcul 4 constitué de façon connue par un microprocesseur ou tout autre dispositif équivalent couplé à des moyens de mémorisation non représentés. Le signal radioélectrique S et le bruit atmosphérique B sont appliqués respectivement à l'entrée du convertisseur analogique-numérique 3 au travers de l'amplificateur 1 et de la cellule de détection 2. Le convertisseur analogique-numérique fournit des échantillons numériques du signal et/ou du bruit au dispositif de calcul 4.

Le dispositif de calcul 4 est convenablement programmé pour effectuer des traitements numériques sur les échantillons qu'il reçoit du convertisseur analogique-numérique 3 de la façon qui est illustrée par l'organigramme de la figure 2. Suivant cet organigramme, le dispositif de calcul 4 prélève, à l'étape représentée en 5, les échantillons fournis par le convertisseur analogique-numérique 3 afin de discriminer, lors d'une seconde étape 6, les échantillons représentatifs soit d'un signal utile, soit d'un bruit atmosphérique. La discrimination est éventuellement réalisée, soit en prenant comme premier critère, un critère de niveau pour comparer chaque échantillon reçu à un niveau de seuil déterminé correspondant à une valeur actuelle déjà estimée du bruit, soit encore, en suivant un deuxième critère consistant à suivre l'évolution de l'amplitude des échantillons transmis au dispositif de calcul 4.

Suivant le premier critère, chaque échantillon est comparé à la valeur connue actuelle du bruit et si le niveau de l'échantillon recueilli est supérieur à un nombre déterminé de décibels, le dispositif de calcul 4 classe cet échantillon comme appartenant à un signal utile, dans le cas contraire, si le niveau de l'échantillon recueilli est inférieur à un nombre déterminé de décibels alors cet échantillon est considéré comme un échantillon de bruit atmosphérique.

Pour appliquer le deuxième critère, le dispositif de calcul 4 mesure la pente d'évolution du signal. Si la pente est faible le dispositif de calcul 4 assimile le signal appliqué à son entrée à du bruit atmosphérique, par contre, si la pente est forte le signal d'entrée est considéré comme étant dû à un signal utile.

L'utilisation du premier et du deuxième critère permet de ne pas prendre en compte les échantillons qui correspondent aux signaux utiles pour ne pas fausser le calcul de l'estimation du bruit.

Le calcul de l'estimée de bruit s'effectue ensuite selon une troisième étape référencée 7 qui consiste à effectuer une moyenne sur un nombre déterminé d'échantillons de bruit détectés.

Ce calcul permet de définir la probabilité pour que l'amplitude instantanée du bruit dépasse d'un nombre déterminé de décibels la valeur estimée du bruit calculé précédemment, ce qui permet de définir, suivant l'étape représentée en 8, le seuil de détection en fonction du taux de fausses alarmes acceptable par le récepteur.

Enfin, à l'étape 10, une comparaison permet en fonction du seuil qui est déterminé à l'étape 8, de comparer la valeur de chaque échantillon à la valeur du seuil défini précédemment à l'étape 8 et d'identifier de façon précise chaque échantillon reçu comme étant un échantillon purement de bruit ou un échantillon de signal utile.

La détermination du seuil de détection est illustré par le diagramme de la figure 3 qui représente une courbe de probabilité $P(x)$ d'avoir à l'entrée du récepteur une amplitude de bruit $k$ $E_{eff}$, à partir d'une puissance de bruit $k.E_{eff}^2$.

Cette loi de probabilité est généralement définie par une relation de la forme

$$P_k = 1 - \frac{1}{\sqrt{2\pi}} \int_{-\infty}^{k} e^{-\frac{k^2}{2}} \, dk$$

c'est-à-dire la probabilité de détecter à tort un signal utile au-delà d'un seuil $S$ de bruit.

Cependant la valeur du seuil qui est ainsi déterminée ne permet pas d'éliminer à elle seule des détections de parasites impulsionnels. Pour pallier cet inconvénient le dispositif de calcul 4 peut être judicieusement programmé pour qu'en cours de balayage du plan de fréquence à surveiller par le récepteur de radiosurveillance, un arrêt de balayage pendant un intervalle de temps $\tau$ déterminé se produise sur la fréquence du signal dont l'amplitude dépasse le seuil de détection, en échantillonnant le signal et en comptant, durant la période $\tau$ d'arrêt du balayage, le nombre de fois où le niveau du signal détecté est supérieur au seuil de détection.

La discrimination d'un signal par rapport à un parasite est dès lors simple à obtenir, le dispositif de calcul 4 pouvant comparer le nombre d'occurrences obtenues à un nombre déterminé préalablement enregistré. A titre d'exemple un rapport de 7/10 pourra être jugé suffisant pour discriminer l'arrivée d'un signal utile d'un parasite.

## Revendications

1. Procédé pour l'ajustage automatique du seuil de détection de signaux radioélectriques dans le plan de fréquence de balayage d'un récepteur de radiosurveillance, comparant l'amplitude des échantillons de bruit et/ou de signal utile à une valeur de seuil de détection obtenue en calculant (7) une valeur moyenne des échantillons de bruit sur un nombre déterminé N d'échantillons et à éliminer les détections de parasites impulsionnels en cours de balayage du plan de fréquence à surveiller en arrêtant le balayage durant une période de temps déterminée lorsque l'amplitude du signal à l'entrée du récepteur dépasse le seuil de détection pour calculer le nombre de fois où l'amplitude du signal est supérieur au seuil de détection et comparer le nombre d'occurrences obtenues à un nombre prédéterminé et caractérisé en ce qu'il sépare (6) sur une voie de réception unique les échantillons de bruit des échantillons de signal utile

2. Dispositif pour la mise en oeuvre du procédé selon la revendication 1, caractérisé en ce qu'il comprend, d'une part, un amplificateur logarithmique (1) une cellule de détection (2) et un convertisseur analogique-numérique (3) tous trois couplés en série pour convertir en signaux numériques le signal radioélectrique appliqué à l'entrée de l'amplificateur (1) et d'autre part, un dispositif de calcul (4) couplé à la sortie du convertisseur analogique-numérique (3) pour calculer une estimée de la valeur du bruit présent à l'entrée du récepteur.

**Claims**

1. Method for the automatic adjustment of the detection threshold of radio signals in the sweep frequency range of a radio monitoring receiver, comparing the amplitude of the noise and/or useful signal samples with a detection threshold value obtained by computing (7) a mean value of the noise samples over a predetermined number N of samples and eliminating the detections of interference pulses during the sweeping of the frequency range to be monitored by stopping the sweep for a predetermined period of time when the amplitude of the input signal of the receiver exceeds the detection threshold in order to compute the number of times where the amplitude of the signal is greater than the detection threshold and to compare the number of occurrences obtained with a predetermined number and characterised in that it separates (6) the noise samples from the useful signal samples on a single reception channel.

2. Device for implementing the method according to Claim 1, characterised in that it comprises, on the one hand, a logarithmic amplifier (1), a detection cell (2) and an analog-digital converter (3), all three being coupled in series in order to convert the radio signal applied to the input of the amplifier (1) into digital signals and, on the other hand, a computing device (4) coupled to the output of the analog-digital converter (3) in order to compute an estimate of the value of the noise present at the input of the receiver.

**Patentansprüche**

1. Verfahren zum automatischen Einstellen der Detektionsschwelle von Funksignalen im Frequenzdurchlaufplan eines Funküberwachungsempfängers, der die Amplitude von Abtastwerten des Rausch- und/oder Nutzsignals mit einem Detektionsschwellenwert vergleicht, der durch Berechnen (7) eines Mittelwertes der Rausch-Abtastwerte über eine bestimmte Anzahl N von Abtastwerte erhalten wird, wobei die Erfassungen von Störimpulsen im Verlauf des Durchlaufs des zu überwachenden Frequenzplans eliminiert werden, indem der Durchlauf während einer bestimmten Zeitperiode angehalten wird, wenn die Signalamplitude am Eingang des Empfängers die Detektionsschwelle überschreitet, damit die Anzahl berechnet wird, wie oft die Signalamplitude größer als die Detektionsschwelle ist und die Anzahl der erhaltenen Ereignisse mit einer vorbestimmten Zahl verglichen wird, dadurch gekennzeichnet, daß in einem einzigen Empfangskanal die Abtastwerte des Rauschens und die Abtastwerte des Nutzsignals voneinander getrennt werden (6).

2. Vorrichtung zur Durchführung des Verfahrens nach Anspruch 1, gekennzeichnet durch einerseits einen logarithmischen Verstärker (1), einer Detektionszelle (2) und einen Analog/Digital-Umsetzer (3), wobei diese drei in Serie geschaltet sind, um das an den Eingang des Verstärkers (1) angelegte Funksignal in digitale Signale umzusetzen, und andererseits eine Rechenvorrichtung (4), die an den Ausgang des Analog/Digital-Umsetzer (3) angeschlossen ist, um einen Schätzwert für den Wert des am Eingang des Empfängers vorhandenen Rauschens zu berechnen.

FIG.1

SIGNAL D'ENTREE → AMPLIFI-CATEUR (1) → CELLULE DE DETECTEUR (2) → C A N (3) → DISPOSITIF DE CALCUL (4) → DECISION

TAUX DE FAUSSES ALARMES

FIG.2

DEBUT → ECHANTILLONS (5)

BOUCLE DE CALCUL DE L'ESTIMEE DU BRUIT / CRITERE DE NIVEAU / CRITERE DE PENTE (6)

MOYENNE GLISSANTE SUR N ECHANTILLONS (7)

SEUIL DE DETECTION (8)

COMPARAISON → DECISION

FIG.3